# EUROPEAN PATENT APPLICATION

(11) **EP 4 283 819 A1**
(43) Date of publication of application: **29.11.2023**
(21) Application number: 21931528.0
(22) Date of filing: 17.03.2021
(51) Int. Cl.: H02J 7/00, H02J 3/32

(54) **STORAGE BATTERY MANAGEMENT DEVICE, STORAGE BATTERY MANAGEMENT METHOD, AND PROGRAM**

(71) Applicant: KABUSHIKI KAISHA TOSHIBA, Minato-ku Tokyo 105-0023 (JP); Toshiba Energy Systems & Solutions Corporation, Saiwai-ku Kawasaki-shi Kanagawa 2120013 (JP)
(72) Inventor: SASAKI, Koji, Kawasaki-shi, Kanagawa 212-0013 (JP); KASE, Takahiro, Kawasaki-shi, Kanagawa 212-0013 (JP); KOBAYASHI, Takenori, Kawasaki-shi, Kanagawa 212-0013 (JP); MITSUMOTO, Kenji, Kawasaki-shi, Kanagawa 212-0013 (JP); SUMIDA, Yoshihisa, Kawasaki-shi, Kanagawa 212-0013 (JP); TOBA, Koji, Kawasaki-shi, Kanagawa 212-0013 (JP)
(74) Representative: AWA Sweden AB
(86) International application number: PCT/JP2021/010903
(87) International publication number: WO 2022/195777

(57) **Abstract**

A storage battery management device according to the present embodiment includes: an acquisition unit to acquire, as current operation state data of a storage battery system including a plurality of storage batteries, charge/discharge power, a cell voltage, a charge/discharge current, and a temperature of a battery board of the storage battery system; a calculation unit to calculate, by using a digital model capable of reproducing operation of the storage battery system in a simulative manner, a chargeable/dischargeable capacity, a State of Charge (SOC) level change amount, and an SOC maintainable charge/discharge amount being a charge/discharge amount maintaining an SOC level within a predetermined range, the calculation unit performing the calculation on the basis of the charge/discharge power, the cell voltage, the charge/discharge current, the temperature of the battery board, scheduled charge/discharge power being a scheduled value of future charge/discharge power, and upper and lower limit values of an SOC of the storage battery system; and a display control unit to cause a display unit to display the chargeable/dischargeable capacity, the SOC level change amount, and the SOC maintainable charge/discharge amount.

## Description

### FIELD

Embodiments of the present invention relate to a storage battery management device, a storage battery management method, and a program.

### BACKGROUND

In recent years, a storage battery system including multiple storage batteries has been used as, for example, a backup power supply or a power storage device by renewable energy power generation. In addition, with the rise of the adjustment market of the supply and demand of power and the frequency, it is expected that the adjustment business of the supply and demand of power and the frequency utilizing the storage battery system will be activated.

In addition, in the storage battery system, a storage amount varies with charging and discharging. Therefore, conventionally, for example, an operator of the storage battery system looks at a current output [kW] and a state of charge (SOC) [%] on a display screen of a storage battery management device, predicts a transition of the SOC thereafter, and adjusts the output [kW].

### CITATION LIST

### Patent Literature

Patent Literature 1: JP 2013-507628 A
Patent Literature 2: JP 2012-135148 A

### SUMMARY OF THE INVENTION

### Problem to be Solved by the Invention

However, in the above-described conventional technique, for example, when the output [kW] of the storage battery system is changed, the operator needs to re-predict the transition of the SOC thereafter each time, which takes time and effort.

Therefore, the present invention has been made in view of the above circumstances, and an object of the present invention is to provide a storage battery management device, a storage battery management method, and a program, which are capable of calculating and displaying information related to the subsequent transition of the SOC by using the current operation state data of the storage battery system and so forth.

### Means for Solving Problem

A storage battery management device of the present embodiment includes: an acquisition unit to acquire, as current operation state data of a storage battery system including a plurality of storage batteries, charge/discharge power, a cell voltage, a charge/discharge current, and a temperature of a battery board of the storage battery system; a calculation unit to calculate, by using a digital model capable of reproducing operation of the storage battery system in a simulative manner, a chargeable/dischargeable capacity, a State of Charge (SOC) level change amount, and an SOC maintainable charge/discharge amount being a charge/discharge amount maintaining an SOC level within a predetermined range, the calculation unit performing the calculation on the basis of the charge/discharge power, the cell voltage, the charge/discharge current, the temperature of the battery board, scheduled charge/discharge power being a scheduled value of future charge/discharge power, and upper and lower limit values of an SOC of the storage battery system; and a display control unit to cause a display unit to display the chargeable/dischargeable capacity, the SOC level change amount, and the SOC maintainable charge/discharge amount.

### BRIEF DESCRIPTION OF DRAWINGS

FIG. 1 is an overall configuration diagram illustrating an outline of a storage battery system according to an embodiment.
FIG. 2 is a configuration block diagram of a cell module and so forth of the embodiment.
FIG. 3 is a configuration block diagram of a host control device according to the embodiment.
FIG. 4 is a functional configuration block diagram of a control unit of the host control device according to the embodiment.
FIG. 5 is an explanatory diagram illustrating an outline of processing of the host control device according to the embodiment.
FIG. 6 is a schematic diagram illustrating a first display screen example in the host control device according to the embodiment.
FIG. 7 is a schematic diagram illustrating a second display screen example in the host control device according to the embodiment.
FIG. 8 is a schematic diagram illustrating a third display screen example in the host control device according to the embodiment.
FIG. 9 is a flowchart illustrating the processing of the host control device according to the embodiment.

### DETAILED DESCRIPTION

Hereinafter, embodiments of a storage battery management device, a storage battery management method, and a program of the present invention will be described with reference to the drawings.

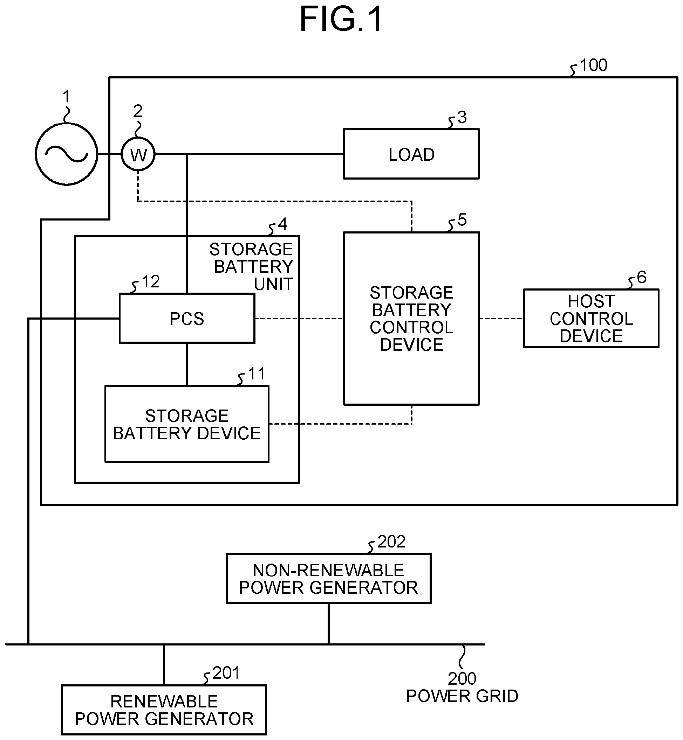

FIG. 1 is an overall configuration diagram illustrating an outline of a storage battery system 100 according to an embodiment. For example, as illustrated in FIG. 1, the storage battery system 100 includes a power meter 2, a storage battery unit 4, a storage battery control device 5, and a host control device 6 (storage battery management device). Note that the configuration of the storage battery system 100 is not limited to this, and the configuration of individual devices constituting the storage battery system 100 is also not limited to the following.

A commercial power supply 1 supplies commercial power. The power meter 2 measures power supplied from the commercial power supply 1. A load 3 is a device that consumes the power.

The storage battery unit 4 charges the power of the commercial power supply 1 on the basis of a measurement result of the power meter 2, or discharges the power to supply the power to the load 3 when the power supply from the commercial power supply 1 is stopped.

The storage battery control device 5 performs local control of the storage battery unit 4. The host control device 6 performs remote control or the like of the storage battery control device 5.

In the above configuration, the load 3 normally operates by receiving power supply from the commercial power supply 1, and operates by receiving power supply from the storage battery unit 4 when the power supply from the commercial power supply 1 is stopped.

The storage battery unit 4 is also connected to a power grid 200. A renewable power generator 201 (renewable energy generator) and a non-renewable power generator 202 (non-renewable energy generator) are connected to the power grid 200. The renewable power generator 201 is a device that generates power by renewable energy (for example, energy by sunlight, solar heat, hydraulic power, wind power, biomass, geothermal heat, or the like). The non-renewable power generator 202 is a device that generates power by non-renewable energy (for example, energy by thermal power, nuclear power, or the like).

With the rise of the adjustment market of the supply and demand of power and the frequency, it is considered that the adjustment business of the supply and demand of power and the frequency utilizing the storage battery system 100 can be performed.

The storage battery unit 4 includes a storage battery device 11 that stores power, and a power conditioning system (PCS) 12 that performs operation of converting DC power supplied from the storage battery device 11 into AC power having a desired power quality and supplying the AC power to a load, etc.

The storage battery device 11 includes a plurality of battery board units, a battery terminal board, etc. Each battery board includes a plurality of cell modules, a plurality of CMUs provided in each cell module, a service disconnect provided between the cell modules, a current sensor, a contactor, etc.

The battery board includes a BMU. A communication line of each CMU and the output line of the current sensor are connected to the BMU.

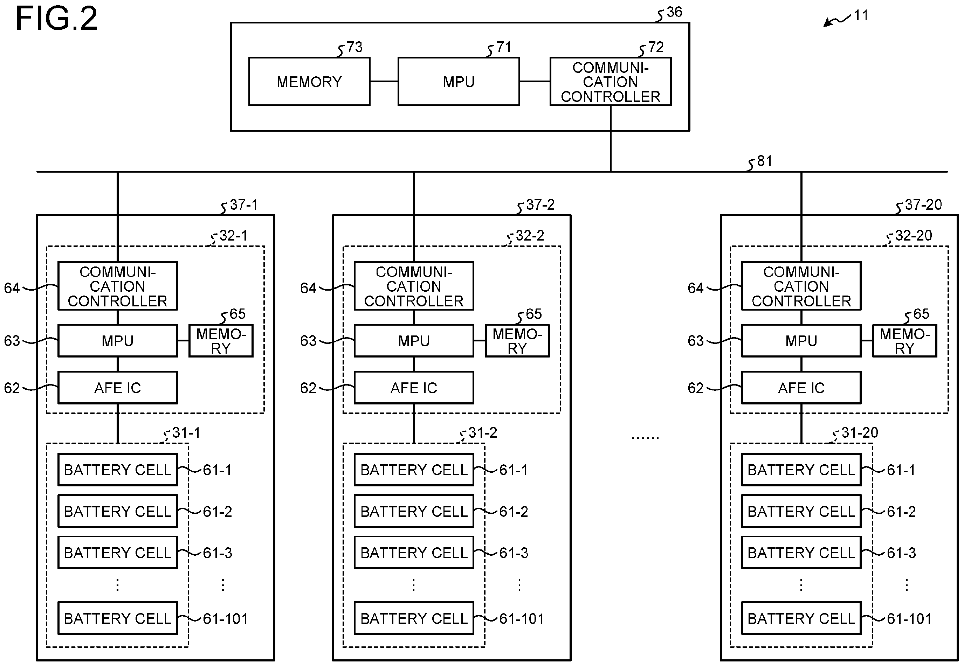

Here, detailed configurations of the cell module, the CMU, and the BMU will be described. FIG. 2 is a configuration block diagram of the cell module and so forth of the embodiment. For example, as illustrated in FIG. 2, each of the cell modules 31-1 to 31-20 includes battery cells 61-1 to 61-101 connected in series.

The CMUs 32-1 to 32-20 include an analog front end IC (AFE IC) 62 for measuring the voltage (cell voltage) of the battery cells constituting the corresponding cell modules 31-1 to 31-20 and the temperature of a predetermined place, an MPU 63 for controlling all corresponding CMUs 32-1 to 32-20, a communication controller 64 conforming to the controller area network (CAN) standard for performing communications via a CAN 81 with the BMU 36, and a memory 65 for storing voltage data and temperature data corresponding to the voltage of each cell.

In the following description, cell modules 31-1 to 31-20 and corresponding CMUs 32-1 to 32-20 are collectively referred to as storage battery modules 37-1 to 37-20. For example, a combination of the cell module 31-1 and the corresponding CMU 32-1 is referred to as a storage battery module 37-1. Hereinafter, the storage battery modules 37-1 to 37-20 are also simply referred to as the storage battery module 37 unless otherwise distinguished.

In addition, the BMU 36 includes an MPU 71 that controls the entire BMU 36, a communication controller 72 conforming to the CAN standard for performing CAN communication with the CMUs 32-1 to 32-20, and a memory 73 that stores voltage data and temperature data transmitted from the CMUs 32-1 to 32-20.

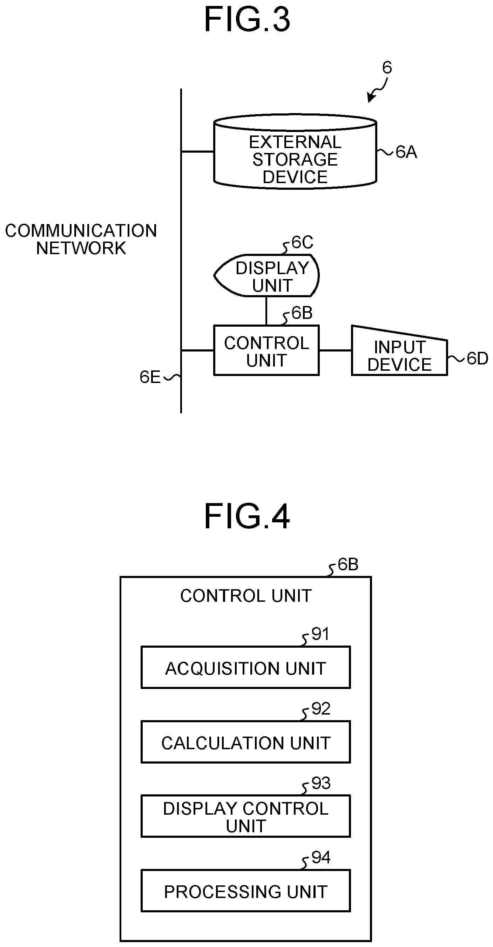

FIG. 3 is a configuration block diagram of the host control device 6 according to the embodiment. The host control device 6 is configured as a computer device, and includes, for example, as illustrated in FIG. 3, an external storage device 6A, a control unit 6B that controls the entire host control device 6, a display unit 6C that displays various types of information to the operator, an input device 6D for the operator to input various types of information, and a communication network 6E for performing communication between the control unit 6B and the external storage device 6A and between the control unit 6B and an external device such as the storage battery control device 5.

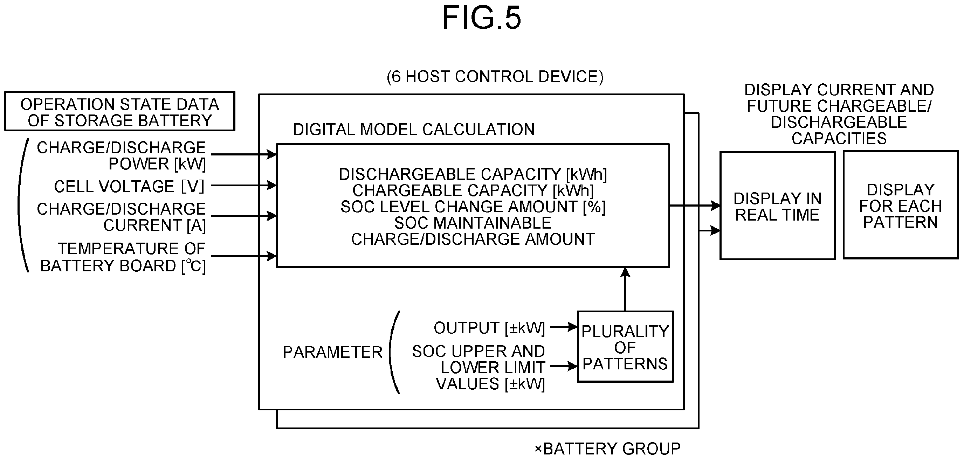

Here, FIG. 4 is a functional configuration block diagram of the control unit 6B of the host control device 6 according to the embodiment. For example, as illustrated in FIG. 4, the control unit 6B includes an acquisition unit 91, a calculation unit 92, a display control unit 93, and a processing unit 94 as a functional configuration. In the following description, FIG. 5 is also referred to. FIG. 5 is an explanatory diagram illustrating an outline of processing of the host control device 6 according to the embodiment.

The acquisition unit 91 acquires various types of information from an external device (storage battery unit 4, storage battery control device 5, or the like). For example, the acquisition unit 91 acquires, as the current operation state data of the storage battery system 100, data of charge/discharge power [kW], a cell voltage [V], a charge/discharge current [A], and a temperature [°C] of the battery board of the storage battery unit 4 of the storage battery system 100.

The calculation unit 92 executes various types of calculation processing on the basis of various types of information. For example, by using a digital model (for example, a simulator program, an equivalent circuit, or the like) that can reproduce operation of the storage battery unit 4 of the storage battery system 100 in a simulative manner, the calculation unit 92 calculates chargeable/dischargeable capacity (dischargeable capacity [kWh], chargeable capacity [kWh]), an SOC level change amount [%], and an SOC maintainable charge/discharge amount that is a charge/discharge amount capable of maintaining the SOC level within a predetermined range on the basis of the charge/discharge power, the cell voltage, the charge/discharge current, the temperature of the battery board, scheduled charge/discharge power that is a scheduled value of future charge/discharge power, and SOC upper and lower limit values of the storage battery unit 4. In the following description, the scheduled charge/discharge power is also referred to as "output" (FIG. 5). When the output is a positive value, it represents "scheduled discharge power", and when the output is a negative value, it represents "scheduled charge power". In addition, the output and the SOC upper and lower limit values are part of parameters set by the operator.

The display control unit 93 executes control to display various types of information on the display unit 6C. The display control unit 93 causes the display unit 6C to display (display in real time or the like), for example, the chargeable/dischargeable capacity, the SOC level change amount, and the SOC maintainable charge/discharge amount calculated by the calculation unit 92.

In addition, the calculation unit 92 calculates, by using the digital model, the chargeable/dischargeable capacity, the SOC level change amount, and the SOC maintainable charge/discharge amount for multiple patterns in which at least one of the scheduled charge/discharge power and the upper and lower limit values of the SOC is different, on the basis of the charge/discharge power, the cell voltage, the charge/discharge current, the temperature of the battery board, the scheduled charge/discharge power, and the SOC upper and lower limit values. In this case, the display control unit 93 causes the display unit 6C to display (such as display for each pattern) the chargeable/dischargeable capacity, the SOC level change amount, and the SOC maintainable charge/discharge amount for the multiple patterns. Note that the multiple patterns may be optionally set by an operator, for example, or may be set by setting a maximum value, a minimum value, an average value, or the like regarding each parameter from a past trend.

The calculation unit 92 further calculates, by using the digital model, a chargeable/dischargeable time on the basis of the charge/discharge power, the cell voltage, the charge/discharge current, the temperature of the battery board, the scheduled charge/discharge power, and the upper and lower limit values of the SOC. In this case, the display control unit 93 causes the display unit 6C to display the chargeable/dischargeable capacity, the SOC level change amount, the SOC maintainable charge/discharge amount, and the chargeable/dischargeable time for the multiple patterns by a navigation window, and switches the display for each pattern in accordance with the user operation that uses the navigation window.

In addition, the display control unit 93 displays a stop position in a display area of the SOC level change amount in the navigation window. The stop position represents a capacity of the storage battery unit 4 of the storage battery system 100 at a time when discharge is stopped while keeping the capacity of the storage battery unit 4.

In operation of the storage battery system 100 for suppressing output fluctuation in the power grid 200, the calculation unit 92 calculates an SOC level change amount corresponding to a case where the present charge/discharge power is retained, and calculates, on the basis of the SOC level change amount, second charge/discharge power which is a value after the change of the charge/discharge power for bringing the SOC level close to a predetermined SOC target value. In this case, the display control unit 93 displays the second charge/discharge power in the navigation window.

In other words, when the present charge/discharge power is retained in the operation of the storage battery system 100 for suppressing the output fluctuation in the power grid 200, the calculations are made to find how the SOC level changes over time and how much the charge/discharge power should be changed from the past operation pattern in order to approximate to the SOC target value. The amount of change in charge/discharge power may be selected and determined by the operator.

Moreover, the calculation unit 92 may be a functional object provided in a cloud computing system (not illustrated).

In addition, the calculation unit 92 may periodically estimate a deterioration state of the storage battery unit 4 (storage battery module 37) on the basis of the operation state data of the storage battery unit 4 including the temperature of the battery board. In this case, when the deterioration state of the storage battery unit 4 reaches a predetermined deterioration state threshold, the display control unit 93 causes the display unit 6C to display information for making notification about the deterioration of the storage battery unit 4. In general, the deterioration rate of the battery board increases as the temperature of the battery board increases. Therefore, it is effective to use the temperature of the battery board for estimating the deterioration state of the storage battery unit 4. In addition, information other than the temperature of the battery board may be used to estimate the deterioration state of the storage battery unit 4.

In addition, the processing unit 94 executes processing other than the processing performed by each of the units 91 to 93.

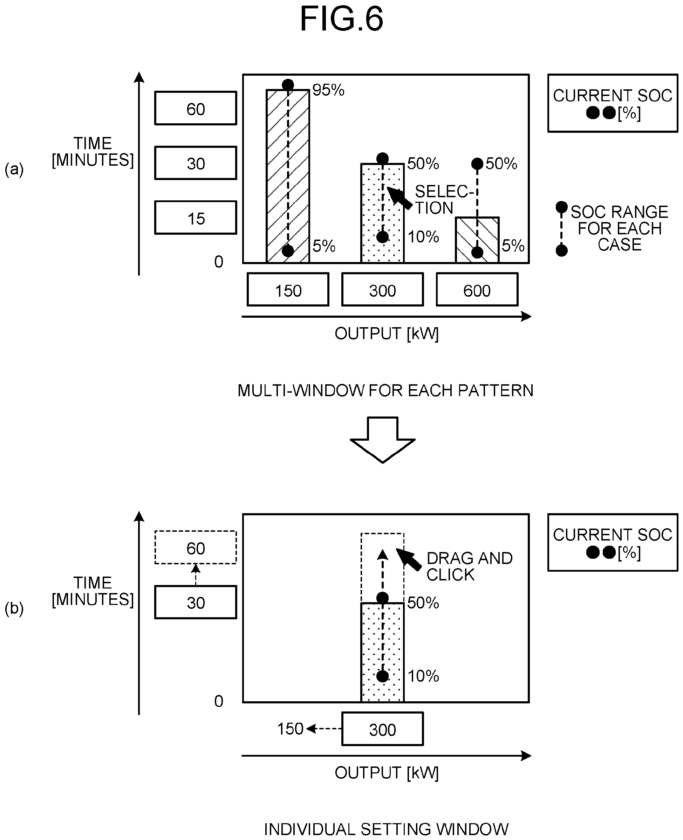

FIG. 6 is a schematic diagram illustrating a first display screen example of the host control device 6 according to the embodiment. In the navigation window (multi-window for each pattern) of FIG. 6(a), a horizontal axis denotes the output [kW], and a vertical axis denotes time (minutes). In addition, the current SOC level (%) is displayed on the right side.

The bar graph for each output (150 kW, 300 kW, 600 kW) represents the dischargeable time (60 min, 30 min, 15 min) for each output. In addition, two filled circles for each output (150 kW, 300 kW, 600 kW) and a broken line between the two filled circles represent SOC ranges (range of SOC upper and lower limit values: 5% to 95%, 10% to 50%, and 5% to 50%) for each output. For example, when the bar graph of 300 kW is selected on this screen, the screen transitions to the screen of FIG. 6(b).

In the navigation window (individual setting window) of FIG. 6(b), the horizontal axis denotes the output [kW], and the vertical axis denotes time (minutes). In addition, the current SOC level (%) is displayed on the right side.

The selected bar graph of 300 kW, the two filled circles, and the broken line between the filled circles are displayed. On this screen, the time and output can be changed by the operator by expanding and contracting the bar graph with mouse operation or the like. For example, operation of upwardly dragging and clicking the bar graph increases time, whereas output decreases.

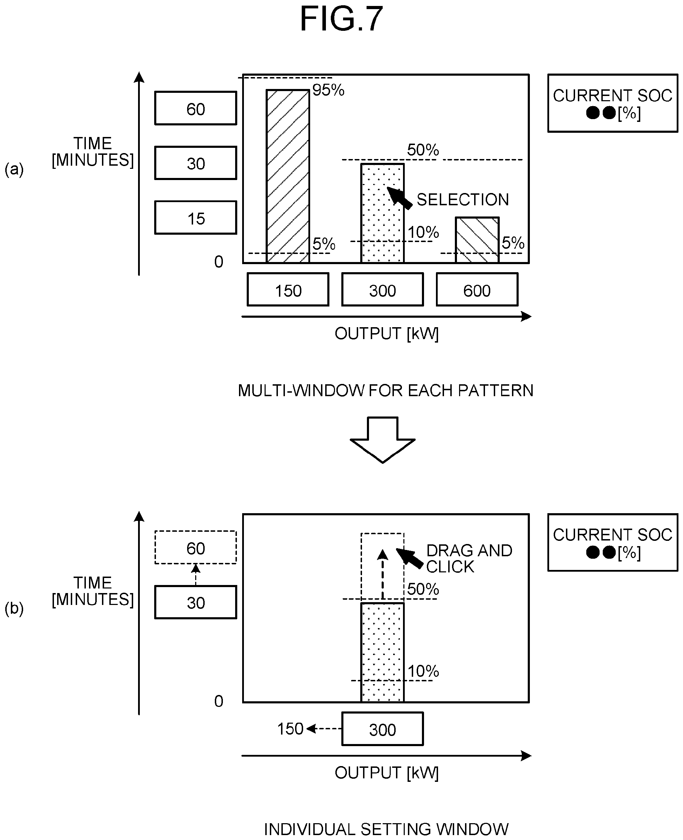

Next, FIG. 7 is a schematic diagram illustrating a second display screen example in the host control device 6 according to the embodiment. The same matters as those in FIG. 6 will not be described repeatedly. In the navigation window (multi-window for each pattern) of FIG. 7(a), upper and lower broken lines for each output (150 kW, 300 kW, 600 kW) represent SOC ranges (5% to 95%, 10% to 50%, and 5% to 50%) for each output. When the bar graph of 300 kW is selected on this screen, the screen transitions to the screen of FIG. 7(b). FIG. 7(b) is similar to FIG. 6(b).

In FIGS. 6 and 7, the lower limit value of the SOC range is the stop position representing a capacity at a time when discharge of the storage battery unit 4 is stopped, but the present invention is not limited thereto. A stop position other than the lower limit value of the SOC range may be separately displayed.

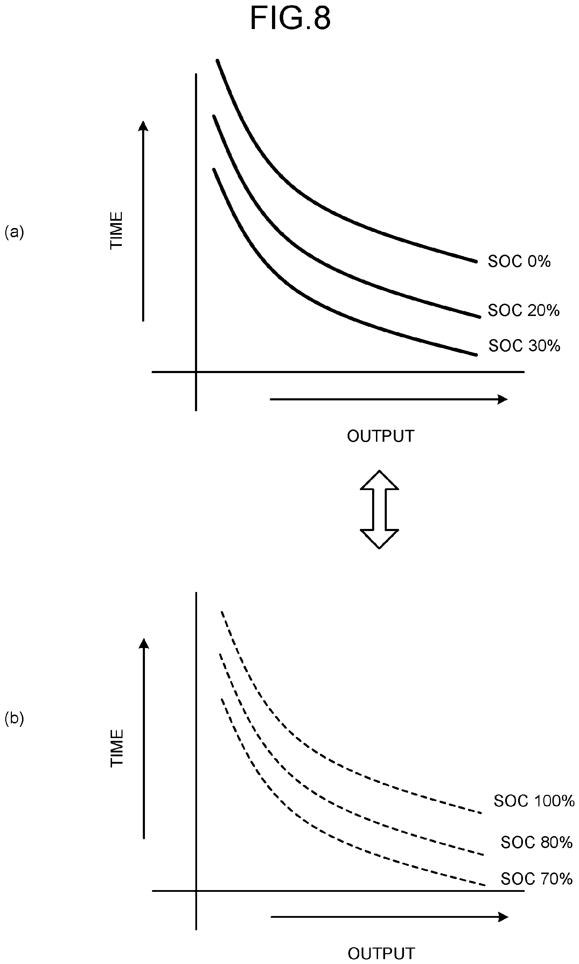

Next, FIG. 8 is a schematic diagram illustrating a third display screen example in the host control device 6 according to the embodiment. In the screen of FIG. 8(a), the horizontal axis denotes output [kW], and the vertical axis denotes time (minutes). The screen of FIG. 8(a) corresponds to the time of discharge of the storage battery unit 4, and illustrates a relationship between magnitude of the output and a length of a time (dischargeable time) in a case where the time of stopping discharging the storage battery unit 4 is set to SOC "0"%, SOC "20"%, and SOC "30"%.

The screen of FIG. 8(b) corresponds to the time of the charging of the storage battery unit 4, and illustrates a relationship between magnitude of the output (negative output) and a length of time (chargeable time) in a case where the time of stopping charging the storage battery unit 4 is set to SOC "100"%, SOC "80"%, and SOC "70"%, respectively.

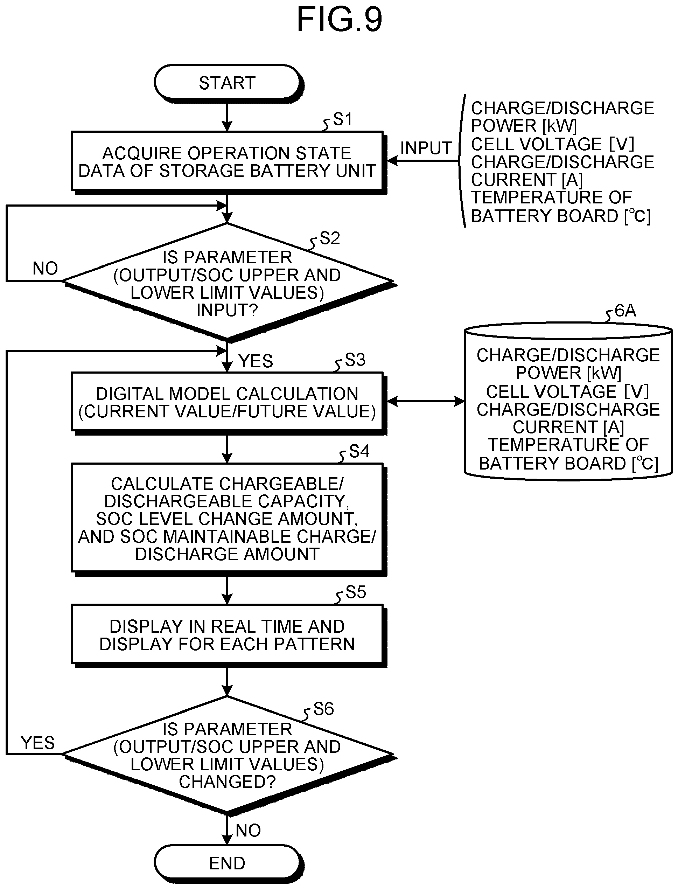

FIG. 9 is a flowchart illustrating processing of the host control device 6 according to the embodiment. In Step S 1, the acquisition unit 91 acquires, as the current operation state data of the storage battery unit 4 of the storage battery system 100, the charge/discharge power [kW], the cell voltage [V], the charge/discharge current [A], and the temperature [°C] of the battery board.

Next, in Step S2, the processing unit 94 determines whether or not a parameter (output/SOC upper and lower limit values) has been input by the operator. In a case of Yes, the step proceeds to Step S3, and in a case of No, the step returns to Step S2.

In Step S3, the calculation unit 92 performs digital model calculation on the basis of the charge/discharge power, the cell voltage, the charge/discharge current, the temperature of the battery board, the scheduled charge/discharge power, and the SOC upper and lower limit values.

Next, in Step S4, the calculation unit 92 calculates, by the digital model calculation, the chargeable/dischargeable capacity (dischargeable capacity [kWh], chargeable capacity [kWh]), the SOC level change amount [%], and the SOC maintainable charge/discharge amount.

Next, in Step S5, the display control unit 93 performs real-time display by the navigation window and performs display for each pattern as illustrated in FIGS. 6 to 8.

Next, in Step S6, the processing unit 94 determines whether or not the parameter (output/SOC upper and lower limit values) has been changed by the operator. In a case of Yes, the step returns to Step S3, and in a case of No, the step ends.

As described above, according to the storage battery system 100 of the present embodiment, by performing the above-described digital model calculation by the host control device 6, it is possible to calculate and display the information (chargeable/dischargeable capacity, SOC level change amount, SOC maintainable charge/discharge amount, chargeable/dischargeable time, etc.) related to the subsequent transition of the SOC by using the current operation state data of the storage battery unit 4. In addition, this calculation and display are automatically performed even when the parameter (output/SOC upper and lower limit values) is changed (Yes in Step S6 in FIG. 9). Therefore, the operator can recognize the information related to the transition of the SOC at all times including the time of changing a parameter by viewing the display, which is convenient.

In addition, with respect to the multiple patterns of parameters, the chargeable/dischargeable capacity, the SOC level change amount, the SOC maintainable charge/discharge amount, and the chargeable/dischargeable time are displayed in the navigation window, and display switching for each pattern can be performed in accordance with the user operation using the navigation window (see FIGS. 6 and 7), whereby the convenience of the operator can be further enhanced.

Moreover, by displaying the stop position indicating a capacity at a time when discharge of the storage battery unit 4 is stopped in the display area of the SOC level change amount in the navigation window, the convenience of the operator is further enhanced.

Additionally, in operation of the storage battery system 100 for suppressing the output fluctuation in the power grid 200, the SOC level change amount corresponding a case where the present charge/discharge power is retained can be calculated. Then, the second charge/discharge power, which is a value after changing the charge/discharge power for bringing the SOC level close to the predetermined SOC target value, can be calculated and displayed on the basis of the SOC level change amount. As a result, for example, it is possible to avoid or delay a state in which the SOC level sticks to the vicinity of the SOC upper limit value or the vicinity of the SOC lower limit value.

The calculation unit 92 can be implemented as a functional object arranged in a cloud computing system. This makes it possible to easily deal with, for example, a case where the calculation amount of the calculation unit 92 is large.

In addition, the deterioration state of the storage battery unit 4 may be periodically estimated on the basis of the operation state data of the storage battery unit 4 including the temperature of the battery board, and the estimated deterioration state may be notified to the operator by display when the deterioration state reaches a predetermined deterioration state threshold. With such processing, the operator can quickly recognize the deterioration of the storage battery unit 4 and take necessary measures.

In addition, by performing the display as illustrated in FIG. 8, the operator can easily recognize a relationship between the output and the time for each of the upper and lower limit values of the SOC, which is more convenient.

The host control device 6 functioning as the storage battery management device of the present embodiment can have a hardware configuration utilizing a normal computer that includes a control device such as a central processing unit (CPU), a storage device such as a read only memory (ROM) and a random access memory (RAM), an external storage device such as a hard disk drive (HDD) and a compact disc (CD) drive device, a display device such as a display unit, an input device such as a keyboard and a mouse, etc.

Therefore, a computer program executed by the host control device 6 functioning as the storage battery management device of the present embodiment can be provided by being recorded on a computer-readable recording medium such as a CD-ROM, a flexible disk (FD), a CD-R, and a digital versatile disk (DVD) as a file in an installable format or an executable format.

In addition, the program may be stored on a computer connected to a network such as the Internet and provided by being downloaded via the network. Moreover, the program may be provided or distributed via a network such as the Internet.

In addition, the program may be provided by being incorporated in a ROM or the like in advance.

Although embodiments of the present invention have been described, the embodiments have been presented as examples, and are not intended to limit the scope of the invention. This novel embodiment can be implemented in various other forms, and various omissions, substitutions, and changes can be made without departing from the gist of the invention. These embodiments and modifications thereof are included in the scope and gist of the invention, and are included in the invention described in the claims and the equivalent scope thereof.

For example, without displaying the multi-window for each pattern as illustrated in FIGS. 6(a) and 7(a), an individual setting window as illustrated in FIGS. 6(b) and 7(b) may be displayed, and display of multiple patterns may be switched by a mouse operation or the like.

In addition, the storage battery management device may be implemented by a computer device that is different from the host control device 6.

## Claims

1. A storage battery management device comprising:
an acquisition unit to acquire, as current operation state data of a storage battery system including a plurality of storage batteries, charge/discharge power, a cell voltage, a charge/discharge current, and a temperature of a battery board of the storage battery system;
a calculation unit to calculate, by using a digital model capable of reproducing operation of the storage battery system in a simulative manner, a chargeable/dischargeable capacity, a State of Charge (SOC) level change amount, and an SOC maintainable charge/discharge amount being a charge/discharge amount maintaining an SOC level within a predetermined range, the calculation unit performing the calculation on the basis of the charge/discharge power, the cell voltage, the charge/discharge current, the temperature of the battery board, scheduled charge/discharge power being a scheduled value of future charge/discharge power, and upper and lower limit values of an SOC of the storage battery system; and
a display control unit to cause a display unit to display the chargeable/dischargeable capacity, the SOC level change amount, and the SOC maintainable charge/discharge amount.

2. The storage battery management device according to claim 1, wherein
the calculation unit calculates, by using the digital model, the chargeable/dischargeable capacity, the SOC level change amount, and the SOC maintainable charge/discharge amount, with respect to multiple patterns in which at least one of the scheduled charge/discharge power and the upper and lower limit values of the SOC is different, the calculation unit performing the calculation on the basis of the charge/discharge power, the cell voltage, the charge/discharge current, the temperature of the battery board, the scheduled charge/discharge power, and the upper and lower limit values of the SOC, and
the display control unit causes the display unit to display the chargeable/dischargeable capacity, the SOC level change amount, and the SOC maintainable charge/discharge amount with respect to the multiple patterns in a switchable manner for each pattern.

3. The storage battery management device according to claim 2, wherein
the calculation unit further calculates, by using the digital model, a chargeable/dischargeable time on the basis of the charge/discharge power, the cell voltage, the charge/discharge current, the temperature of the battery board, the scheduled charge/discharge power, and the upper and lower limit values of the SOC, and
the display control unit
causes the display unit to display, in a navigation window, the chargeable/dischargeable capacity, the SOC level change amount, the SOC maintainable charge/discharge amount, and the chargeable/dischargeable time, with respect to the multiple patterns, and
switches display for each pattern in accordance with a user operation using the navigation window.

4. The storage battery management device according to claim 3, wherein the display control unit displays a stop position in a display area of the SOC level change amount in the navigation window, the stop position representing a capacity of the storage battery system at a time when discharge is stopped while keeping the capacity of the storage battery system.

5. The storage battery management device according to claim 3, wherein, in operation of the storage battery system for suppressing output fluctuation in a power grid to which the storage battery system and a renewable energy generator are connected,
the calculation unit
calculates the SOC level change amount corresponding to a case where the present charge/discharge power is retained, and
calculates, on the basis of the SOC level change amount, second charge/discharge power having a value after change of the charge/discharge power for bringing the SOC level close to a predetermined SOC target value, and
the display control unit displays the second charge/discharge power in the navigation window.

6. The storage battery management device according to claim 1, wherein the calculation unit is a functional object provided in a cloud computing system.

7. The storage battery management device according to claim 1, wherein
the calculation unit periodically estimates a deterioration state of the storage battery system on the basis of the operation state data of the storage battery system including a temperature of the battery board, and,
when the deterioration state reaches a predetermined deterioration state threshold, the display control unit causes the display unit to display information for making notification about deterioration of the storage battery system.

8. A storage battery management method comprising:
an acquisition step of acquiring, as current operation state data of a storage battery system including a plurality of storage batteries, charge/discharge power, a cell voltage, a charge/discharge current, and a temperature of a battery board of the storage battery system;
a calculation step of calculating, by using a digital model capable of reproducing operation of the storage battery system in a simulative manner, a chargeable/dischargeable capacity, a State of Charge (SOC) level change amount, and an SOC maintainable charge/discharge amount being a charge/discharge amount maintaining an SOC level within a predetermined range, the calculation unit performing the calculation on the basis of the charge/discharge power, the cell voltage, the charge/discharge current, the temperature of the battery board, scheduled charge/discharge power being a scheduled value of future charge/discharge power, and upper and lower limit values of an SOC of the storage battery system; and
a display control step of causing a display unit to display the chargeable/dischargeable capacity, the SOC level change amount, and the SOC maintainable charge/discharge amount.

9. A program causing a computer to function as:
an acquisition unit to acquire, as current operation state data of a storage battery system including a plurality of storage batteries, charge/discharge power, a cell voltage, a charge/discharge current, and a temperature of a battery board of the storage battery system;
a calculation unit to calculate, by using a digital model capable of reproducing operation of the storage battery system in a simulative manner, a chargeable/dischargeable capacity, a State of Charge (SOC) level change amount, and an SOC maintainable charge/discharge amount being a charge/discharge amount maintaining an SOC level within a predetermined range, the calculation unit performing the calculation on the basis of the charge/discharge power, the cell voltage, the charge/discharge current, the temperature of the battery board, scheduled charge/discharge power being a scheduled value of future charge/discharge power, and upper and lower limit values of an SOC of the storage battery system; and
a display control unit to cause a display unit to display the chargeable/dischargeable capacity, the SOC level change amount, and the SOC maintainable charge/discharge amount.
